# EUROPEAN PATENT APPLICATION

(11) **EP 3 965 296 A1**
(43) Date of publication of application: **09.03.2022**
(21) Application number: 20194687.8
(22) Date of filing: 04.09.2020
(51) Int. Cl.: H03K 5/135, H03K 5/24

(54) **TRUE SINGLE-PHASE CLOCK STORAGE UNIT FOR TRIPLE MODULAR REDUNDANCY CELL**

(71) Applicant: IHP GmbH - Innovations for High Performance Microelectronics / Leibniz-Institut für innovative Mikroelektronik, 15236 Frankfurt (Oder) (DE)
(72) Inventor: Schrape, Oliver, 15236 Frankfurt (Oder) (DE); Balashov, Alexey, 15236 Frankfurt (Oder) (DE); Andjelkovic, Marko, 15236 Frankfurt (Oder) (DE); Krstic, Milos, 15236 Frankfurt (Oder) (DE)
(74) Representative: Eisenführ Speiser

(57) **Abstract**

The invention is directed to a TSPC storage unit (100) comprising a data-forwarding stage (102) configured to receive an input binary data signal (D) and a clock signal (C0) and to generate and provide, in dependence on a clock-based forwarding trigger event in the received clock signal (C0), a first comparison binary value (A0) that is correlated to the value of the input binary data signal. It also comprises a comparison stage (106) configured to compare the first comparison binary value (A0) with an external second comparison binary value (A2), and, in dependence on a clock-based comparison trigger event immediately consecutive to the forwarding trigger event, and when the first and the second comparison binary values have the same binary value, to provide, an output binary value (Q0) correlated to the first comparison binary value, thereby reducing a propagation delay when compared to known TSCP storage units.

## Description

The present invention is directed to a true-single phase storage unit and to a method for operating said true-single phase clock storage unit, and to a triple modular redundancy cell.

J. Yuan and C. Svensson's publication in IEEE Journal of Solid-State Circuits, 24(1):62-70, Feb 1989 entitled "High-speed CMOS circuit technique", describes a true single-phase clock (TSCP) storage unit capable of operation with clock frequencies in excess of 200 MHz. Typically, three of these known TSCP storage units are combined with a majority voter to implement a fault tolerant triple modular redundancy (TMR) module, which outputs that value

It would be beneficial to provide an alternative TSCP storage unit suitable for implementation in TMR modules that is subject to less signal propagation delay and enables a reduction of occupied area.

According to a first aspect of the present invention a true single-phase clock storage unit is disclosed. The true single-phase clock storage unit, also referred to as storage unit herewithin, comprises a data-forwarding stage that is configured to receive an input binary data signal and a clock signal. The data-forwarding stage is also configured to generate and provide a first comparison binary value that is correlated to the value of an input binary data signal. The first comparison binary value is provided in dependence on an occurrence of a clock-based forwarding trigger event in a received clock signal. The storage unit of the first aspect also includes a comparison stage that is configured to receive the clock signal, the first comparison binary value from the data-forwarding unit and an external second comparison binary value for comparing to the first comparison binary value. The comparison stage is further configured to provide via a data output interface, an output binary value that is correlated to the first comparison binary value when the first and the second comparison binary values have the same binary value. The output binary value is provided in dependence on an occurrence of a clock-based comparison trigger event, which is defined as a clock-based trigger event immediately consecutive to the forwarding trigger event.

The data forwarding stage thus receives the input binary data signal that is indicative of input binary data. The input binary data has, at any given moment, one of two possible values, typically referred to "0" and "1" or HIGH and LOW. It also receives the clock signal, that is a signal that alternates between two possible values, referred to as HIGH and LOW. A trigger event is a predetermined clock signal form, such as a predetermined level or a predetermined transition between levels or a predetermined combination of levels and transitions. When the forwarding trigger event occurs, the forwarding stage provides a first comparison binary value that is correlated to a current value of the input binary data. The first comparison binary value provided upon the occurrence of the forwarding trigger event is thus always related in an univocal way to the current value of the input binary data.

The first comparison binary value is provided to the comparison stage. The comparison stage is also configured to receive the external second comparison value and to compare the first and the second comparison value. The comparison stage also receives the clock signal and is configured to provide, when the first and the second comparison binary values have the same binary value, and in dependence on an occurrence of the clock-based comparison trigger event, the output binary value. The output binary value is under these circumstances, a value correlated to the first comparison binary value. The comparison trigger event is a corresponding trigger event that immediately follows the forwarding trigger event.

The true single-phase clock storage unit of the first aspect of the invention is therefore advantageously configured to provide the output binary value correlated to a given first comparison value, and thus also univocally correlated to the value of the input binary data at a given point in time, after the occurrence of two consecutive trigger events, referred to as the forwarding trigger event and the comparison trigger event.

In the following, embodiments of the true single-phase clock storage unit of the first aspect of the invention will be described.

It is worth noting that in a sequential operation where clock-based trigger events occur repeatedly, and where the forwarding trigger event and the comparison trigger event are identical, i.e., share the same signal form of the clock signal, a given comparison trigger event at the comparison stage is also a next forwarding trigger event for the data-forwarding stage. In a particular embodiment the data-forwarding stage is configured to provide the first comparison binary value during occurrence of a predetermined clock signal level, i.e. for as long as the received clock signal assumes the predetermined clock signal level. The TSPC storage unit of this embodiment is thus referred to as a level-triggered latch that is configured to provide the output binary value in dependence on the value of the external second comparison binary value. In an embodiment, the level-triggered latch is a low-level-triggered latch, wherein the forwarding trigger events are occurrences of a LOW or "0" level of the clock signal. In an alternative embodiment, the level-triggered latch is a high-level-triggered latch, wherein the forwarding trigger events are occurrences of a HIGH or "1" level of the clock signal.

Alternatively, in another embodiment, the data-forwarding stage is configured to provide the first comparison binary value upon occurrence of a transition from a first level of the received clock signal to a second level of the clock signal different than the first level. The storage unit of this embodiment is thus referred to as an edge-triggered flip-flop that is configured to provide the output binary value in dependence on the value of the external second comparison binary value. In an embodiment, the edge-triggered flip-flop is a positive-edge-triggered flip-flop, wherein the forwarding trigger events are transitions of the clock signal from a LOW or "0" level to a HIGH or "1" level. In an alternative embodiment, the edge-triggered flip-flop is a negative-edge-triggered flip-flop, wherein the forwarding trigger events are transitions of the clock signal from a HIGH or "1" level to a LOW or "0" level.

In some embodiments, the forwarding trigger event and the comparison trigger event correspond to a same type of trigger event, e.g.., an occurrence of a predetermined clock signal level or a predetermined clock signal transition. A first occurrence of the trigger event is a forwarding trigger event for the data-forwarding unit which outputs the first comparison binary value after a forwarding delay time. The first occurrence of the trigger event is not significant for the comparison stage because it has not yet received the first comparison binary value. A second occurrence of the trigger event has two effects. It is the first significant comparison trigger event for the comparison stage and causes the comparison stage to provide the binary value after a comparison delay time, when the first and the second comparison binary values have the same binary value. In addition it is the second significant forwarding trigger event for the data forwarding unit. The n^{th} trigger event will therefore be the n^{th} significant trigger event for the data forwarding unit but the (n-1)^{th} significant trigger event for the comparison unit. Upon occurrence of the n^{th} trigger event (for n>1), the output binary value is a value correlated to the first comparison binary value provided by the data forwarding unit upon occurrence of the (n-1)^{th} trigger event, which is in turn correlated to the value of the input binary data at the time of the occurrence of said (n-1)^{th} trigger event.

In an alternative embodiment, the forwarding trigger event and the comparison trigger event correspond to different types of trigger events. For instance, as a non-limiting example, the forwarding trigger event is an occurrence of a predetermined transition between a first and a second clock signal level, e.g. from LOW to HIGH, and the comparison trigger event is an occurrence of a predetermined clos stage can i.e. an occurrence of a predetermined clock signal level or a predetermined clock signal transition.

In a preferred embodiment of true single-phase clock storage unit of the invention, data-forwarding stage comprises a first MOS stage that is configured to receive the input binary data signal at two gates of MOS transistors of a first polarity and a second polarity respectively and the clock signal at a gate of a third transistor of the first polarity. The first and the second polarity is one of an "n" and "p" polarity respectively, so that the MOS transistors are either n-MOS or p-MOS in dependence on their polarity. The first stage is configured to provide, at a first output node, the first comparison binary value.

In order to provide the first comparison value, the two MOS transistors of the first polarity (either n-MOS or p-MOS) are together configured to control a connection of the first output node to a first supply voltage line. Also, the MOS transistor of the second polarity (either p-MOS when the transistors of the first polarity are n-MOS or otherwise n-MOS) is configured to control a connection of the first output node to a second supply voltage line different than the first supply voltage line. In an embodiment, the first supply voltage line is configured to provide a voltage value higher than that provided by the second supply voltage line. In a particular embodiment the first supply voltage line supplies a positive voltage amount referred to as VCC and the second supply voltage line is ground. The first and the second supply voltage lines are configured to supply voltage amounts corresponding to the two levels possible levels of the value of the binary input data, the first comparison binary value, the output binary value and the clock signal.

For example, in a non-limiting embodiment, the two MOS transistors of the first polarity are p-MOS transistors. One p-MOS transistor receives at its gate the value of the input binary data and the other p-MOS transistor receives at its gate the clock signal. They are together arranged to control a connection of the first output node to the first supply voltage line, corresponding in this exemplary embodiment to VCC, and thus to a value of HIGH or "1". Whenever the value of the input binary data and of the clock signal is "0" or LOW, the first output node will be connected to VCC and the binary value at the first output node will be "1" or HIGH value. On the other hand, the transistor of the second polarity is an n-MOS transistor that receives at its gate the value of the input binary data and that is arranged to control a connection of the first output node to the second supply voltage line, corresponding in this particular embodiment to GND, and thus to a value of LOW or "0". Whenever the value of the input binary data is "1" or HIGH, irrespectively of the current value of clock signal, the first output node will be connected to VCC and the binary value at the first output node will be "1" or HIGH value. If the current value of the clock signal is "1" or HIGH and the value of the input binary data is "0" the first output node is neither connected to the first nor to the second supply voltage line.

Thus, whenever the clock signal is LOW (or in an alternative embodiment whenever the clock signal is HIGH), the binary value at the first output node of the first MOS stage is always the complementary value of the current input binary data (or in an alternative embodiment, the same binary value as the current input binary data), and it is therefore correlated thereto. That value is the first comparison binary value that is provided to the comparison stage. The occurrence of a LOW level in this particular embodiment is regarded as the forwarding trigger event.

This first MOS stage suffices for embodiments of a TSCP storage unit based on level-triggered latches. Alternatively, for other embodiments of TSCP storage unit, in particular those based on edge-triggered flip-flops, the data-forwarding stage comprises a first MOS stage configured, analogously to the first MOS stage described above, to receive the input binary data signal at two gates of MOS transistors of a first polarity and a second polarity respectively and the clock signal at a gate of a third transistor of the first polarity. In this first stage the two MOS transistors of the first polarity are configured to control a connection of a first MOS-stage output node to the first supply voltage line, and the MOS transistor of the second polarity is configured to control a connection of the first MOS-stage output node to the second supply voltage line different than the first supply voltage line. Also, the first MOS stage is configured to provide, at the first MOS-stage output node, a first MOS stage output signal.

The first MOS stage of this embodiment has a similar function as the first MOS stage of the previous embodiment. However the binary value provided at the first MOS-stage output node by the first MOS stage of this particular embodiment is not directly fed to the comparison stage. Instead, it is provided to a second MOS stage of the data-forwarding unit. As detailed above, the binary value provided at the first MOS-stage output node is always the complementary value of the current input binary data, and it is therefore correlated thereto, when the clock signal is HIGH or LOW, depending on the selection of the first and the second polarity and of the first and second supply voltage lines.

As a non-limiting example, in an embodiment, the MOS transistors of the first polarity are p-MOS transistors and the MOS transistor of the second polarity is an n-MOS transistor. The first supply voltage line supplies VCC, corresponding to the binary value of "1" and the second supply voltage line is GND, corresponding to the binary value of "0". In this particular embodiment, when the clock signal is LOW, the binary value provided at the first MOS-stage output node is always the complementary value of the current input binary data.

The second MOS stage is configured to receive the clock signal at two gates of MOS transistors of the first polarity and the second polarity respectively and the first MOS stage output signal at a gate of a third transistor of the second polarity. In the second MOS stage, the MOS transistor of the first polarity is configured to control a connection of a second MOS-stage output node to the first supply voltage line, and the two MOS transistors of the second polarity are together configured to control a connection of the second MOS-stage output node to the second supply voltage line that is different than the first supply voltage line. The second MOS stage of the forwarding stage is thus configured to provide, at the second MOS-stage output node, the first comparison binary value.

The non-limiting example discussed above will now be extended to the second MOS stage. According to the example, the transistors of the first and the second polarity are p-MOS and n-MOS transistors respectively, the first and the second supply voltage lines correspond to VCC and GND, i.e., to the binary values of "1" and "0", respectively, and whenever the clock signal is LOW, the binary value provided at the first MOS-stage output node is always the complementary value of the current input binary data.

Now, whenever the clock signal is LOW or "0", the p-MOS transistor will conduct, thus connecting the first supply voltage line VCC to the second MOS-stage output node. A binary value of "1" is therefore provided at the second MOS-stage output node. Further, when the clock signal and the value of the first stage output signal are "1", the n-MOS transistors will conduct, thus connecting the second supply voltage line GND to the second MOS-stage output node. A binary value of "0" is therefore provided at the second MOS-stage output node.

Summarizing the effect of the first and the second MOS stages of this particular example, the first comparison binary value is provided whenever a change in the clock signal from the LOW level to the HIGH level occurs. This is the forwarding trigger event of this particular embodiment. The value of the first comparison binary value corresponds to that of the input binary data.

In a particular embodiment, which can include any of the technical features of the embodiments described above, the comparison stage of the TSPC storage unit includes a comparison MOS stage that is configured to receive the first and the second comparison binary value at gates of two MOS transistors of a first and a second polarity respectively. Further, it is configured to receive the clock signal at a gate of a fifth transistor of the second polarity. In this comparison stage, the two MOS transistors having the first polarity are configured to control, all together, a connection of the output interface to the first supply voltage line and the three MOS transistors having the second polarity are configured to control, all together, a connection of the second data output interface to the second supply voltage line. Thus, the output interface is electrically connected to the first supply voltage line when both MOS transistors of the first polarity conduct between their respective source and drain terminals. Since each of the MOS transistors has its gate connected to a respective one of the first and the second comparison binary values, the output interface will be connected to the first supply voltage line when both binary comparison values are "0", for p-MOS transistors or when both binary comparison values are "1", for n-MOS transistors. Conversely, the output interface is electrically connected to the second supply voltage line when all three MOS transistors of the second polarity conduct between their respective source and drain terminals. Since two of the MOS transistors have their gate connected to a respective one of the first and the second comparison binary values and the third MOS transistor receives the clock signal at its gate, the output interface will be connected to the first supply voltage line when both binary comparison values are "1" and the clock signal level is HIGH, for n-MOS transistors or when both binary comparison values are "0" and the clock level signal is LOW, for p-MOS transistors. In any case, when the predetermined comparison trigger event occurs, which depends on the actual configuration of the polarities of the transistors, the comparison stage provides the output binary value that is correlated with the first comparison binary value when its binary value coincides with the external second comparison binary value.

For instance, in a preferred embodiment, two p-MOS transistors receive at their gates a respective one of the first and the second binary comparison values, and both together are configured to control an electrical connection between the output interface and the VCC supply line in dependence thereon. Also, three n-MOS transistors, two receiving at their gates a respective one of the first and the second binary comparison values and the third receiving the clock signal, are together configured to control an electrical connection between the output interface and the GND. When both the first and the second binary comparison values are "0" or LOW, the p-MOS transistors conduct and an electrical connection is established between VCC and the output interface. Also, neither of the two n-MOS transistors connected to the binary comparison values conduct, so there is no effective electrical connection between GND and the output interface, irrespectively of the current value of the clock signal. Thus, the output binary value corresponds to VCC and it is "1" or HIGH.

On the other hand, when both the first and the second binary comparison values are "1" or HIGH, neither of the p-MOS transistors conduct and no effective electrical connection is established between VCC and the output interface. On the other hand, both n-MOS transistors connected to the binary comparison values conduct, and an effective electrical connection between GND and the output interface is established when the n-MOS transistor connected to the clock signal also conducts, i.e. when the clock signal is HIGH or "1". Thus, the output binary value, when the clock signal is HIGH, corresponds to GND and it is therefore "0" or LOW.

In cases where the comparison binary values are not equal, the output interface is connected neither to the first nor to the second supply voltage line, since always one of the two n-MOS and one of the two p-MOS transistors receiving the first and the second comparison binary values will not conduct.

Thus, whenever the clock signal is HIGH, and the first and the second comparison binary values are equal, the output binary value at the output interface is always the complementary value of the first (or the second) comparison binary value, and it is therefore correlated thereto. Thus, the clock signal having a HIGH value is, in this particularly embodiment the comparison trigger event. A similar comparison trigger event is in another embodiment a transition from a LOW to a HIGH level in the clock signal. In alternative embodiments, the clock signal having a LOW level or a transition from a HIGH to a LOW level is the comparison trigger event.

According to a second aspect of the present invention, a triple modular redundancy (TMR) cell with integrated majority voter is described. The TMR cell of the second aspect comprises three true single-phase clock storage units according to any one of embodiments described above with respect to the first aspect of the invention. The three TSPC storage units are interconnected according to the following explanation.

The respective data-forwarding stages of the three storage units are configured to receive a respective input binary data signal.

The respective comparison stages are connected to the data-forwarding stage of the given storage unit and to the data-forwarding stage of one of the remaining two storages units, such that each of the three comparison stages is connected to a respective different pair of forwarding stages. Thus each comparison stage is configured to compare the first comparison binary value provided by the data-forwarding unit of the same TSPC storage unit to the first comparison binary value provided by one of the remaining two of the TSPC storage unit, which, for the given comparison stage acts as the second comparison binary value.

Finally, the respective output interfaces of the three comparison stages are connected.

The TMR cell of the second aspect thus shares the advantages of the TSPC storage unit of the first aspect or of any of its embodiments.

In the following, embodiments of the TMR cell of the second aspect of the invention will be described.

In an embodiment, the respective data-forwarding stages of the three storage units are connected, so that same the input binary data signal is provided to all three TSPC storage units. In an alternative embodiment, each of the three storage units receive a respective input binary signal which is generated, for instance, by respective dedicated logic, but that is indicative of a given binary value that is provided to the three data-forwarding stages.

For the sake of simplicity, the three TSPC storage units will be referred to as TSCP0, TSPC1 and TSPC2 and the first comparison binary values provided by their respective data-forwarding stages will be referred to as A0, A1 and A2. In a particular embodiment, the comparison stage of TSPC0 is configured to compare A0 and A1, the comparison stage of TSPC1 is configured to compare A1 and A2 and comparison stage of TSPC2 is configured to compare A2 and A0. A configuration wherein A0-A2, A1-A0 and A2-A1 are compared in TSPCO, TSPC1 and TSPC2 respectively is also implemented in an alternative embodiment.

Typically, under normal operating conditions, the values of A0, A1 and A2 are the same. However, single event transients caused for instance by radiation may affect the TMR cell by changing the value of one or more of A0, A1 and A2. A change of two or three of A0, A1 and A2 is far less probable than a change of just one of the values. If one of them is changed, for instance A0, the two TSCP storage unit configured to use A0 for comparison with A1 and A2 respectively will not provide a significant output. However, that comparison unit comparing the unchanged values of A1 and A2 will output a significant output binary value univocally correlated to A1 and A2, thereby successfully bypassing the erroneous value A0.

In a particular embodiment, wherein each of the three storage units is configured to receive a common clock signal. In an alternative embodiment, each of the three TSPC storage unit receive a different clock signal, particularly clock signals being phase-shifted with respect to each other. In this embodiment, the clock signals are phase-shifted such that the start of the forwarding trigger event and the start of the comparison trigger event happen at different point in times in each of the three TSPC storage units of the TMR cell.

In a preferred embodiment, the triple modular redundancy cell further comprises a driving stage, preferably an inverter, connected to the data output interfaces of the comparison stages of the three true single-phase clock storage units and configured to provide, as driving stage output data, a binary value corresponding to the complementary value of that output binary value provided at least twice by the three true single-phase clock storage units. The driving stage is preferably an inverter, and most preferably comprises two MOS transistors of different polarities and with connected gates, wherein the n-MOS transistor controls a connection of the output node of the inverter to that supply voltage line associated to LOW and the p-MOS transistor controls a connection of the output node of the inverter to that supply voltage line associated to HIGH.

In another embodiment, advantageously configured to mitigate single event transients, the triple modular redundancy cell, additionally or alternatively comprises a data-input delay unit that is connected to at least two of the data-forwarding stages of the three storage units and configured to delay the input binary data signal, so that variations of the value of the input binary data signal reach the three data-forwarding stages at different points in time.

In a particularly simple embodiment a first delay unit for providing an output signal correlated to an input signal after a predetermined first delay time is connected to the data input of one of the TSPC storage cells and a second delay unit for providing an output signal after a predetermined second delay time is connected to the data input of another one of the TSPC storage cells. Thus, variations of the value of the input binary data signal are received at the data input interfaces at different times.

According to a third aspect of the present invention, a method for operating a true single-phase clock storage unit is presented. The method comprises:
- receiving a clock signal
- receiving an input binary data signal indicative of input binary data having, at any given moment, an input binary data value among two possible binary values;
- generating and providing, in dependence on an occurrence of a clock-based forwarding trigger event in the received clock signal, a first comparison binary value that is correlated to the binary value of an input binary data signal;
- receiving the first comparison binary value from the data-forwarding unit and an external second comparison binary value for comparing to the first comparison binary value;
- providing, value when the first and the second comparison binary values have the same binary value, and in dependence on an occurrence of a clock-based comparison trigger event immediately consecutive to the forwarding trigger event, an output binary value that is correlated to the first comparison binary.

The method of the third aspect thus shares the advantages of the TSPC storage unit of the first aspect or of any of its embodiments.

It shall be understood that the TSPC storage unit of claim 1, the TMR cell of claim 7, and the method for operating a TSPC storage unit of claim 12, have similar and/or identical preferred embodiments, in particular, as defined in the dependent claims.

It shall be understood that a preferred embodiment of the present invention can also be any combination of the dependent claims or above embodiments with the respective independent claim.

These and other aspects of the invention will be apparent from and elucidated with reference to the embodiments described hereinafter.

In the following drawings:
Fig. 1A shows a schematic block diagram of a known triple modular redundancy cell using true single-phase clock flip flops and guard gates.
Fig. 1B shows a schematic block diagram of a known majority voter using three guard gates.
Fig. 1C shows a schematic circuit diagram of a known guard gate.
Fig. 2 shows a schematic block diagram of an embodiment of a true single-phase clock storage unit.
Fig. 3A shows a schematic circuit diagram of another embodiment of a true single-phase clock storage unit.
Fig. 3B shows a time diagram of an exemplary clock signal.
Fig. 4 shows a schematic circuit diagram of another embodiment of a true single-phase clock storage unit.
Fig. 5 shows a schematic block diagram of an embodiment of a triple modular redundancy cell including three true single-phase clock storage units.
Fig. 6A shows a schematic block diagram of another embodiment of a triple modular redundancy cell including three true single-phase clock storage units and a single event transient filter unit.
Fig. 6B shows a schematic block diagram of an exemplary single event transient filter unit including a data-input delay unit.
Fig. 6C shows a schematic diagram of an alternative single event transient filter unit.
Fig. 7 shows a schematic flow diagram of an embodiment of a method for operating a true single-phase clock storage unit.

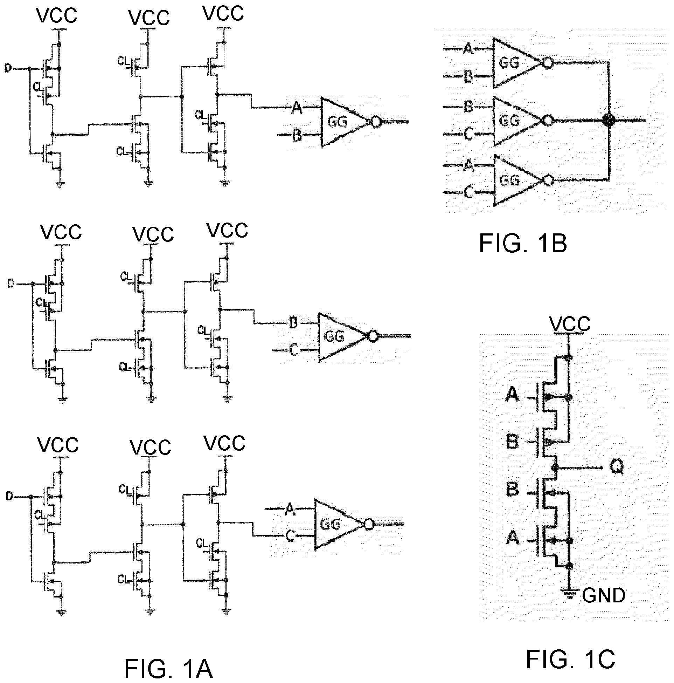

Fig. 1A shows a schematic block diagram of a known triple modular redundancy (TMR) cell using true single-phase clock (TSPC) flip flops and guard gates (GG). The triple modular redundancy cell of Fig. 1A comprises three TSPC positive edge triggered flip flops with an inverting output that are configured to provide as the respective output A, B and C, a value corresponding to the complementary of the binary value of the binary input data D at the time of occurrence of a positive edge in the clock signal CL. The outputs of the three TSPC storage units are provided to a majority voter. In the case of Figs. 1A, 1B and 1C the majority voter uses guard gates (GG), also referred to as C-element gates or two-input transition AND gates (TAG), as exemplarily shown in detail in Fig. 1C. By connecting three guard gates in parallel and shorting the outputs, a majority voter is achievable. In case of an error in any of the signals or values provided at the outputs of the TSPC storage units, only one guard gate drives the output node. For instance, if for any reason C is different than A and B, only the upper guard gate of Fig. 1B drives the output node. This is clear from Fig. 1C, which shows a schematic circuit diagram of a known guard gate. The output of the guard gate Q will be "1", i.e. correspond to VCC, whenever A=B=0. In this case, only the p-MOS transistors of the guard gate will conduct, creating an electric path between the output node Q and a first supply voltage line VCC. If, however, A=B=1, the n-MOS transistors will conduct, creating an electric path between the output node Q and a second supply voltage line GND. Thus, in this case, the value at the output guard gate will correspond to 0. In summary, when both input signals have the same binary value, the output will be the complementary binary value of the input value. If, on the other hand, A is not equal to B, the output node will not be connected to any of the first or second supply voltage lines and the value at the output node is not determined. If all guard gates have equal input values, i.e., A=B=C, all will drive the output node together.

In such a TMR cell, as shown in Fig. 1A, the propagation delay of the input signal depends on the number of stages of each TSPC-storage unit and the majority voter. In this particular TMR cell, and including the corresponding guard gate of the majority voter, there are four stages each of which introduces a corresponding propagation delay.

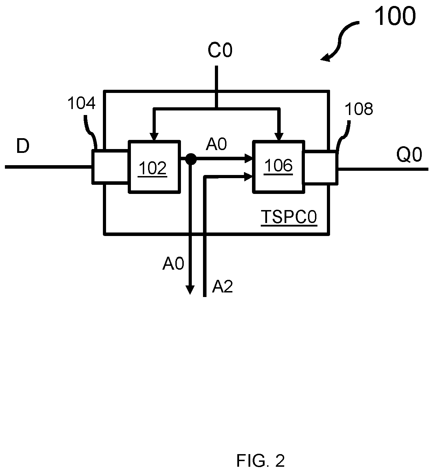

Fig. 2 shows a schematic block diagram of an embodiment of a true single-phase clock storage unit with reduced propagation delay. The TSPC-storage unit 100 comprises a data-forwarding stage that is configured to generate and provide, in dependence on an occurrence of a clock-based forwarding trigger event in a received clock signal C0, a first comparison binary value A0 that is correlated to the value of an input binary data D received via a data input interface 104. For example, the clock-based forwarding trigger event is an occurrence of a LOW or a HIGH level in the clock signals. During the occurrence of said LOW or HIGH phase, any change in the binary value of the input binary data signal causes a change in the first comparison binary value, in accordance with the given univocal correlation. In another example, the clock-based forwarding trigger event is an occurrence of a transition from a LOW to a HIGH level or from a HIGH to a LOW level in the clock signal. In this particular example the first comparison binary value is correlated to the value of the input binary data signal at the time of the occurrence of the given transition.

The TSPC storage unit also comprises a comparison stage 106 which is configured to receive the clock signal C0, the first comparison binary value A0 from the data-forwarding unit and an external second comparison binary value A2 for comparing to the first comparison binary value. In dependence on an occurrence of a clock-based comparison trigger event, the comparison stage is configured to provide, via a data output interface 108, an output binary value Q0 that is correlated to the first comparison binary value A0 when the first and the second comparison binary values A0, A2 have the same binary value. The comparison trigger event is a clock-based trigger event consecutive to the forwarding trigger event. For example, the clock-based comparison trigger event is an occurrence of a LOW or a HIGH level in the clock signals. In another example, the clock-based comparison trigger event is an occurrence of a transition from a LOW to a HIGH level or from a HIGH to a LOW level in the clock signal.

Thus, by integrating at least part of the majority voter in the comparison stage, a reduction of the propagation delay can be achieved when compared to similar known circuits.

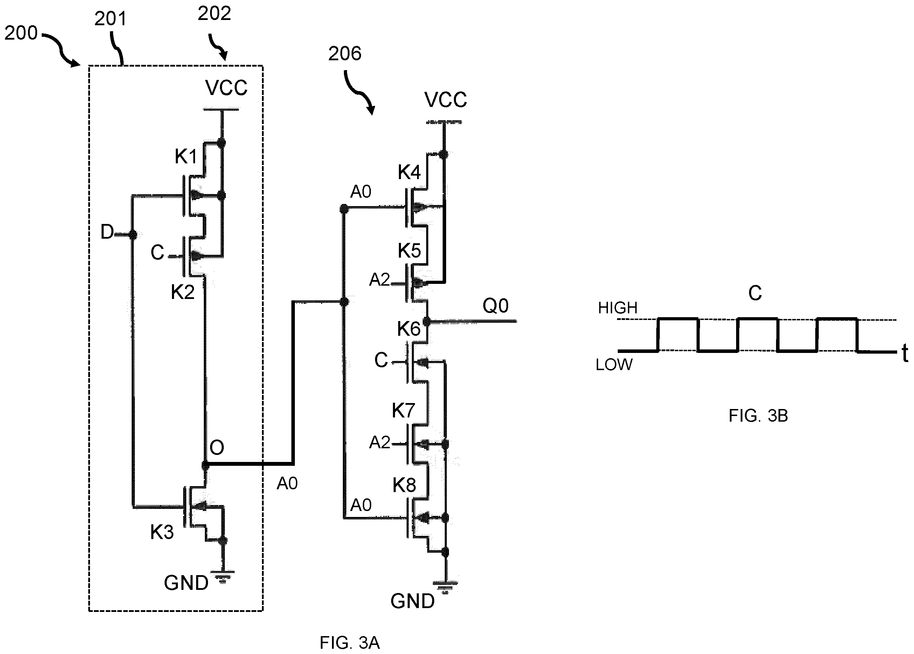

Fig. 3A shows a schematic circuit diagram of another embodiment of a true single-phase clock storage unit and Fig. 3B shows a time diagram of an exemplary clock signal with a signal alternating between two voltage levels, labelled HIGH and LOW and corresponding exemplarily to voltage values given by VCC and GND. The clock signal of Fig. 3B is a non-limiting example of a clock signal that can be used for the TSPC storage cell. Other clock signals having different wave forms, frequency and/or duty cycles can also be used.

The TSPC storage unit 200 includes a data-forwarding stage 202 that comprises a first MOS stage 201. The first MOS stage is configured to receive the input binary data signal D indicative of the input binary data at two gates of MOS transistors of a first polarity and a second polarity respectively. In this particular TSPC storage unit D is received at the gate terminal of MOS transistor K1, which is a p-MOS transistor having thus a first polarity. It is also received at the gate terminal of MOS transistor K3, which is an n-MOS transistor, having thus a second polarity different from the first polarity of K1. The clock signal C is received at a gate terminal of a third MOS transistor K2 of the first polarity, i.e.; a p-MOS transistor. The first stage is configured to provide, at a first output node O, the first comparison binary value A0.

In the first stage, the two p-MOS transistors K1, K2 are configured to control a connection of the first output node O to a first supply voltage line VCC. In addition, the n-MOS transistor is configured to control a connection of the first output node O to a second supply voltage line GND different than the first supply voltage line. VCC corresponds to the binary value "1" and GND corresponds to the binary value "0". Whenever D is "1" and irrespectively of the current value of the clock signal C, the binary value at the first output node will be "0", since the n-MOS transistor K3 will conduct, creating an effective electrical connection between the first output node O and GND. In addition, when D is "0" and C is LOW, an effective electrical path is created connecting VCC and O and thus, the binary value at O is "1" under such circumstances. Therefore, the first MOS stage 201 provides, at the first output node, upon occurrence of the forwarding trigger event, which in this particular example is an occurrence of a LOW level in the clock signal. When the clock signal is LOW, the first MOS stage is configured to provide, as the first binary comparison value, a binary value univocally correlated to the value of the input binary data at that moment. The correlation in this particular example is that the first binary comparison value is the complementary of the value of D during the occurrence of the forwarding trigger event.

In alternative first MOS stages, not shown, the MOS transistors of the first polarity are n-MOS transistors and the MOS transistors of the second polarity are p-MOS transistors. Additionally or alternatively, the first supply voltage corresponds to GND and the second supply voltage line corresponds to VCC. For example, in a first MOS stage where the transistors or the first polarity are n-MOS transistors controlling an electrical connection between VCC and O, whenever a HIGH clock signal level occurs, as a forwarding trigger event, the binary value at the first output node is the same as that of the binary input data.

Also, in Fig. 3A, the comparison stage includes a comparison MOS stage 206. The comparison MOS stage is configured to receive the first and the second comparison binary value A0, A2 at gates of two MOS transistors of a first and a second polarity. In Fig 3A, p-MOS transistors K4 and K5 receive, at their respective gates, the value A0 and A2 respectively. Further, n-MOS transistors K7 and K8 receive, at their respective gates, the value A2 and A0 respectively. In addition the clock signal is received at a gate of a fifth transistor K6 of the second polarity, in this case an n-MOS transistor.

In the comparison MOS stage, the two MOS transistors having the first polarity, e.g. p-MOS transistors K4 and K5, are configured to control a connection of the data output interface Q0 to a first supply voltage line VCC. Conversely, the three MOS transistors having the second polarity, e.g. n-MOS transistors K6, K7 and K8, are configured to control a connection of the second data output interface Q0 to the second supply voltage line GND. The order in which the transistors of a given polarity are arranged is not relevant. For example, in an alternative MOS comparison stage, K4 receives A2 and K5 receives A0. Also C is received, in different MOS comparison stages at K7 or at K8.

The output interface is effectively connected to VCC whenever A0 and A2 are "0". In this case, the value at the data output interface is "1", corresponding to VCC. Also, whenever A0 and A2 are "1" and the clock signal is HIGH, the value at the data output interface is "0" since an effective electrical connection is established between the output interface and GND. In this example, the comparison trigger event corresponds to the clock signal having a HIGH level. When this occurs, the binary value at the data output interface Q0 is the complementary value of A0 and A2, when they have the same binary value. Otherwise, when A0 and A2 do not have the same binary value, the data output interface is neither connected to VCC nor to GND and the value is thus undetermined and depends on a previous value at the output interface, and on a load that is connected to said data output interface.

By partially integrating the majority voter in the comparison stage not only a reduction of the propagation delay can be achieved, but also a reduction of the number of transistors. According to Fig. 1A and 1C,the minimum number of transistors needed for the guard gate and the stage immediately preceding the guard gate amounts to 7 transistors. The guard gate of Fig. 1C includes four transistors and the stage immediately preceding the guard gate includes three transistors, as it can be seen in Fig. 1A. The comparison stage substitutes these two stages and requires only five transistors.

The TSCP storage unit 200 of Fig. 3A is configured as a level triggered latch.

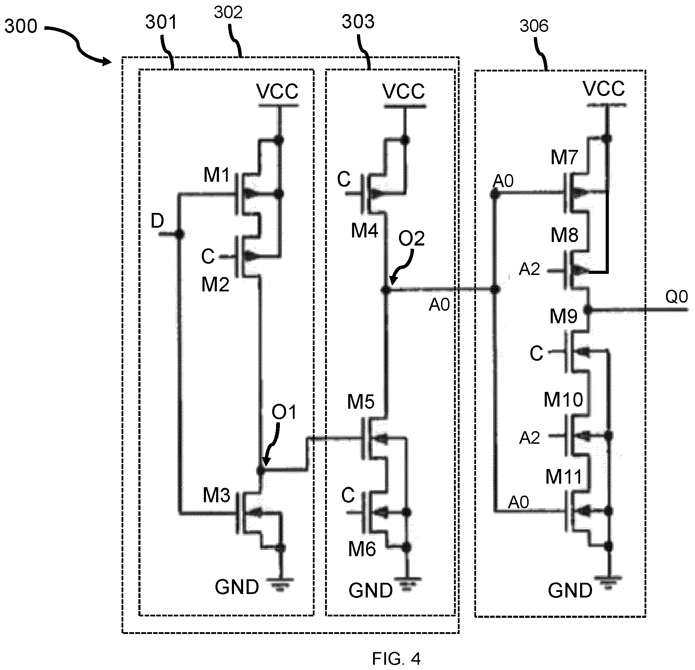

Fig. 4 shows a schematic circuit diagram of another embodiment of a true single-phase clock storage unit 300. The data-forwarding unit 302 of the TSPC storage unit 300 includes a first MOS stage that is analogous to the first MOS stage 201 described with reference to Fig. 3A. The respective transistors are labelled as K1-K3 in Fig. 3A and as M1-M3 in Fig.4 However, the first MOS-stage output node O1 of the first MOS stage 301 is not directly connected to the comparison stage, which in this particular example is a comparison MOS stage 306 but to a second MOS stage 303. The second MOS stage 303 is configured to receive the clock signal at two gates of MOS transistors of the first polarity and the second polarity respectively, in this example, p-MOS transistor M4 and n-MOS transistor M6. The first stage output signal provided by the first MOS stage 301 at the first MOS-stage output node O1 is received at a gate of a third transistor of the second polarity, in this case n-MOS transistor M5.

In the second MOS stage, the p-MOS transistor M4 is configured to control a connection of a second MOS-stage output node O2 to a first supply voltage line VCC, and the two n-MOS transistors M5 and M6 are configured to control a connection of the second MOS-stage output node O2 to a second supply voltage line (GND) different than the first supply voltage line. The second MOS stage is thus configured to provide, at the second MOS-stage output node O2, the first comparison binary value A0.

The first comparison binary value A0 is provided to the MOS comparison stage 306, which is analogous to the MOS comparison stage 206 of Fig. 3A.

The TSCP storage unit 300 of Fig. 4 is configured as a positive edge triggered flip flop.

The exemplary schematic electrical circuit of Fig. 4 can be directly compared with the schematic electrical circuit of Fig. 1A combined with the guard gate of Fig. 1C. The number of transistors needed for the TSPC flip flop with partially integrated majority voter is smaller than the number needed in known TSPC flip flops. Also, the propagation delay exhibited by TSPC storage cell 300 is less than that exhibited by the circuit of Fig. 1A, for transistors having identical characteristics. In this particular example, the propagation delay is estimated by only three stages. The comparison stage shares the logic function of the majority voter and an inverting functionality, which allows for implementation of a TMR cell with low overhead.

In other alternative TSPC storage unit, the MOS transistors of the first polarity are n-MOS transistors and the MOS transistors of the second polarity are p-MOS transistors. Additionally or alternatively, the first supply voltage corresponds to GND and the second supply voltage line corresponds to VCC. Depending on the implementation of the different stages, the correlation of the output values of a given stage and the input values is either that the output value is equal to the input value or it is its complementary value.

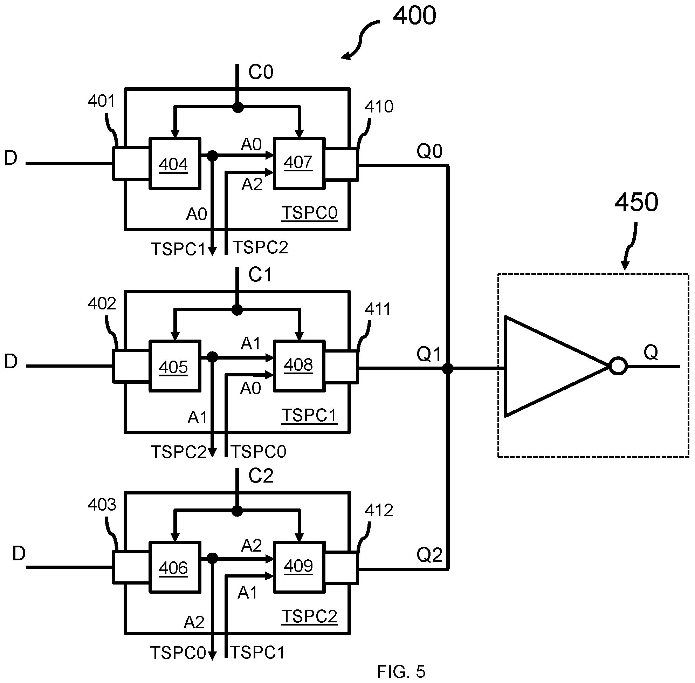

Fig. 5 shows a schematic block diagram of an embodiment of a triple modular redundancy (TMR) cell 400 including three true single-phase clock storage units TSPCO, TSPC1 and TSPC2.

In the TMR cell 400 the respective data input interfaces 401, 402, 403 of the three storage units TSPCO, TSPC1 and TSPC2 are connected. In addition, the respective comparison stages are connected to the data-forwarding stage of the given storage unit and to the forwarding stage of one of the remaining two storages units, such that each of the three comparison stages is connected to a respective different pair of forwarding stages. For instance, in TMR cell 400, the comparison stage 407 is connected to the data-forwarding stage 404 of the same TSPC storage cell TSPC0 and to the data-forwarding stage 406 of TSPC2.

Further, the respective data output interfaces 410, 411, 412 of the three comparison stages 407, 408 and 409 are connected. By connecting the data output interfaces, whenever one first comparison binary value is faulty, only one of the comparison stages will drive the data output interface and thus provide a significant binary value output. In an error-free case, where all first comparison binary values are equal, the three comparison stages will drive the data output interface together.

In the TMR cell 400 of Fig. 1, each one of the TSPC storage units receive a respective clock signal C0, C1 and C2, typically the same clock frequency but a different phase. Alternatively, in another TMR cell (not shown) all TSPC storage units receive a single clock signal C with the same frequency, phase and duty cycle.

An example of a TMR cell includes three TSPC storage units as described with respect to Fig. 4 and connected in accordance with the description of Fig. 5. This particular TMR cell is a TMR flip flop with integrated first-half of the voter and shorted outputs. The output is inverting and the propagation delay is estimated by three stages. By connecting all three data output interfaces together, and adding an inverter 450 as a driver, a full majority voter is formed. One main advantage of this implementation is that 3x2 MOS transistors can be saved, due to the integration of the first half of the majority voter in the comparison stage of the TSPC flip flop, or latch. Moreover, due to the integration, a total number of inverting stages is reduced to four, with the inverter 450 as a the driver or driving stage. It will be appreciated that the same result is achieved when the TSPC storage units are connected such that Q0 is obtained from a comparison of AO and A1, Q1 is obtained from a comparison of A1 and A2 and Q2 is obtained from a comparison of A2 and A0.

The driving stage 450 is connected to the data output interfaces 410, 411, 412 of the comparison stages 407, 408, 409 of the three true single-phase clock storage units TSPCO, TSPC1, TSPC2 and configured to provide, as driving stage output data, a binary value Q corresponding to the complementary value of that output binary value Q0, Q1, Q2 provided at least twice by the three true single-phase clock storage units TSPCO, TSPC1, TSPC2.

As a result, the TMR cell allows for a low overhead in silicon area, a low power performance and moreover a short propagation delay of only four stages.

Table 1 summarizes normalized simulation results of different TMR cells including TPSC flip-flop with known variants including a guard gate-based voter. The numbers in the columns represent an average in normal faultless mode.

The different circuits can be distinguished as follows: GG corresponds to a TMR cell comprising three TSPC cells such as those described in Fig. 4 followed by an inverter. iGG corresponds to the circuit shown in Fig. 1A. eGG corresponds to the a TMR cell including three TSPC flip flops as shown in Fig. 1A, each further including an inverting stage prior to the majority voter, and an inverting stage after the majority voter.

**Table 1. Different TMR cells with guard gate voter**

| Properties | TMR Cell variant | | |
|---|---|---|---|
| | GG | iGG | eGG |
| Normalized number of Stages | 1.00 | 1.00 | 1.50 |
| Normalized Device Area | 1.00 | 1.11 | 1.22 |
| Normalized Performance | | | |
| t_{rf} | 1.00 | 1.36 | 0.97 |
| tₚ | 1.00 | 1.20 | 1.17 |
| P | 1.00 | 1.13 | 1.09 |
| PDP | 1.00 | 1.36 | 1.28 |

In table 1, trf refers to the mean of the rise and fall transition of the output value Q, tₚ represents the mean of the propagation delay, measured by half of the supply voltage at the output node. P refers to the average power consumption whereas PDP is the power delay product. The GG TMR cell variant thus offers the best trade-off between area, propagation delay and power consumption.

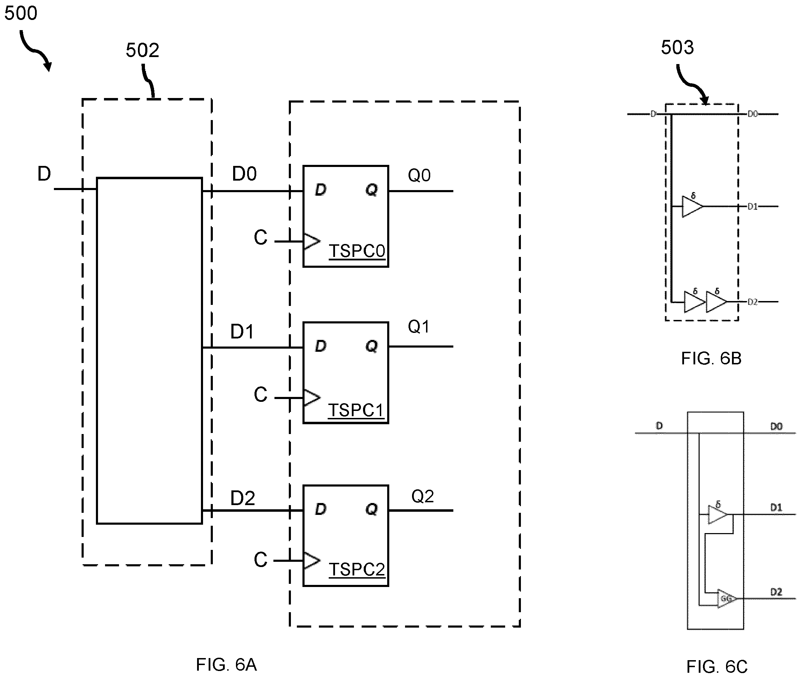

Fig.6 A shows a schematic block diagram of another embodiment of a triple modular redundancy cell including three true single-phase clock storage units TSPCO, TSPC1 and TSPC2 and a single event transient filter unit 502. Fig. 6B shows a schematic block diagram of an exemplary single event transient filter unit comprising a data-input delay unit 503. The data-input delay unit 502 is connected to at least two of the data-forwarding stages of the three storage units and configured to delay the input binary data signal, so that variations of the value of the input binary data signal D reach the three data-forwarding stages at different times D0, D1, D2.

An alternative single event transient filter unit is shown in Fig. 6C. The single event transient filter unit comprises of Fig. 6C comprises one two-input guard gate configured to receive at its input the input binary data signal D and a delayed input binary data signal that is generated by a delay unit. The output of the guard gate D2 is provided to one of the three TSPC storage units. Another one of the storage units receives the input binary data signal D and the remaining storage unit receives the delayed input binary data signal D1.

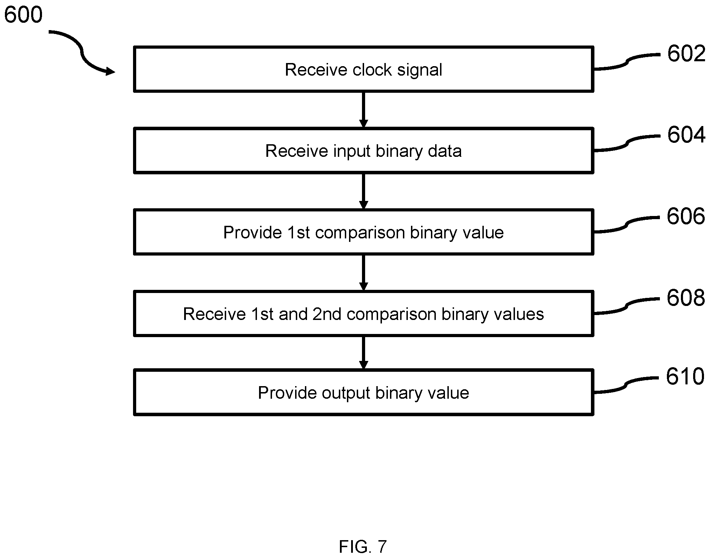

Fig. 7 shows a schematic flow diagram of an embodiment of a method 600 for operating a true single-phase clock storage unit. The method 600 comprises, in a step 602, receiving a clock signal. The method also comprises, in a step 604, receiving an input binary data signal. Further, the method comprises, in a step 606, generating and providing, upon occurrence of a clock-based forwarding trigger event in the received clock signal, a first comparison binary value that is correlated to the value of an input binary data. In addition, the method comprises, in a step 608, receiving the first comparison binary value from the data-forwarding unit and an external second comparison binary value for comparing to the first comparison binary value. Also, the method comprises, in a step 610, providing, upon occurrence of a clock-based comparison trigger event being a clock-based trigger event consecutive to the forwarding trigger event, an output binary value that is correlated to the first comparison binary value when the first and the second comparison binary values have the same binary value.

In summary the invention is directed to a TSPC storage unit comprising a data-forwarding stage configured to receive an input binary data signal and a clock signal and to generate and provide, upon occurrence of a clock-based forwarding trigger event in the received clock signal, a first comparison binary value that is correlated to the value of the input binary data signal. It also comprises a comparison stage configured to compare the first comparison binary value with an external second comparison binary value, and, upon occurrence of a clock-based comparison trigger event immediately consecutive to the forwarding trigger event, and when the first and the second comparison binary values have the same binary value, to provide, an output binary value correlated to the first comparison binary value, thereby reducing a propagation delay when compared to known TSPC storage units.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality.

A single unit, stage or device may fulfil the functions of several items recited in the claims. The mere fact that certain measures are recited in mutually different dependent claims does not indicate that a combination of these measures cannot be used to advantage.

Any reference signs in the claims should not be construed as limiting the scope.

## Claims

1. A true single-phase clock storage unit (TSPC0, 100), comprising:
- a data-forwarding stage (102) configured to receive an input binary data signal and a clock signal and to generate and provide, in dependence on an occurrence of a clock-based forwarding trigger event in the received clock signal (C0), a first comparison binary value (A0) that is correlated to the value of the input binary data signal (D); and
- a comparison stage (106) configured:
- to receive the clock signal (C0), the first comparison binary value (A0) from the data-forwarding unit and an external second comparison binary value (A2) for comparing to the first comparison binary value; and,
- in dependence on an occurrence of a clock-based comparison trigger event immediately consecutive to the forwarding trigger event, and when the first and the second comparison binary values (A0, A2) have the same binary value, to provide, via a data output interface (108), an output binary value (Q0) that is correlated to the first comparison binary value (A0).

2. The true single-phase clock storage unit of claim 1, wherein the data-forwarding stage is configured to provide the first comparison binary value for as long as the received clock signal assumes a predetermined clock signal level.

3. The true single-phase clock storage unit of claim 1, wherein the data-forwarding stage is configured to provide the first comparison binary value upon occurrence of a transition from a first level of the received clock signal to a second level of the clock signal different than the first level.

4. The true single-phase clock storage unit (200) of claims 1 or 2, wherein the data-forwarding stage (202) comprises a first MOS stage (201) configured:
- to receive the input binary data signal (D) at two gates of MOS transistors of a first polarity and a second polarity respectively (K1, K3) and the clock signal (C) at a gate of a third MOS transistor (K2) of the first polarity; and
- to provide, at a first output node (O), the first comparison binary value; and wherein
- the two MOS transistors of the first polarity (K1, K2) are configured to control a connection of the first output node (O) to a first supply voltage line (VCC), and the MOS transistor of the second polarity (K3) is configured to control a connection of the first output node (O) to a second supply voltage line (GND) different than the first supply voltage line.

5. The true single-phase clock storage unit (300) of claims 1 or 3, wherein the data-forwarding stage (302) comprises:
- a first MOS stage (301) configured:
- to receive the input binary data signal (D) at two gates of MOS transistors of a first polarity and a second polarity respectively (M1, M3) and the clock signal (C) at a gate of a third transistor (M2) of the first polarity, wherein the two MOS transistors of the first polarity (M1, M2) are configured to control a connection of a first MOS-stage output node (O1) to a first supply voltage line (VCC), and the MOS transistor of the second polarity (M2) is configured to control a connection of the first MOS-stage output node (O1) to a second supply voltage line (GND) different than the first supply voltage line; and
- to provide, at the first MOS-stage output node (O1), a first MOS stage output signal; the data-forwarding stage further comprising
- a second MOS stage (303) configured:
- to receive the clock signal (C) at two gates of MOS transistors of the first polarity and the second polarity respectively (M4, M6) and the first MOS stage output signal at a gate of a third transistor of the second polarity (M5), wherein the MOS transistor of the first polarity (M4) is configured to control a connection of a second MOS-stage output node (O2) to a first supply voltage line (VCC), and the two MOS transistors of the second polarity (M5, M6) are configured to control a connection of the second MOS-stage output node (O2) to a second supply voltage line (GND) different than the first supply voltage line; and
- to provide, at the second MOS-stage output node, the first comparison binary value (A0).

6. The true single-phase clock storage unit (200, 300) of any of the preceding claims, wherein the comparison stage includes a comparison MOS stage (306) configured:
- to receive the first and the second comparison binary value (A0, A2) at gates of two MOS transistors of a first and a second polarity (M7, M11; M8, M10) respectively;
- to receive the clock signal at a gate of a fifth transistor (M9) of the second polarity; and wherein
- the two MOS transistors (M7, M8) having the first polarity are configured to control a connection of the data output interface (Q0) to a first supply voltage line (VCC) and the three MOS transistors (M9, M10, M11) having the second polarity are configured to control a connection of the data output interface to the second supply voltage line (GND).

7. A triple modular redundancy cell with integrated majority voter (400), comprising three true single-phase clock storage units according to any one of preceding claims (TSPC0, TSPC1, TSPC2), wherein
- the respective data-forwarding stages of the three storage units are configured to receive a respective input binary data signal;
- the respective comparison stages (407) are connected to the data-forwarding stage (404) of the given storage unit (TSPC0) and to the data-forwarding stage (406) of one of the remaining two storages units (TSPC2), such that each of the three comparison stages is connected to a respective different pair of forwarding stages; and wherein
- the respective data output interfaces (410, 411, 412) of the three comparison stages are connected.

8. The triple modular redundancy cell of claim 7, wherein each of the three storage unit is configured to receive a common clock signal;

9. The triple modular redundancy cell of claim 7, wherein each of the three storage units is configured to receive a respective clock signal that is phase-shifted with respect to the other two clock signals.

10. The triple modular redundancy cell (400) of claim 7 or 8, further comprising a driving stage (450) connected to the data output interfaces (410, 411, 412) of the comparison stages (407, 408, 409) of the three true single-phase clock storage units (TSPC0, TSPC1, TSPC2) and configured to provide, as driving stage output data, a binary value (Q) corresponding to the complementary value of that output binary value (Q0, Q1, Q2) provided at least twice by the three true single-phase clock storage units (TSPC0, TSPC1, TSPC2).

11. The triple modular redundancy cell (500) of any of the claims 7 to 10, further comprising a single event transient filter unit connected to the data forwarding stages.

12. The triple modular redundancy cell of claim 11, wherein the single event transient filter unit comprises a data-input delay unit (502) connected to at least two of the data-forwarding stages of the three storage units and configured to delay input binary data signal, so that variations of the value of the input binary data signal (D) reach the three data-forwarding stages at different times (D0, D1, D2).

13. The triple modular redundancy cell of claims 11 or 12, wherein the single event transient filter unit comprises at least one two-input guard gate configured to receive at its input the input binary data signal and a delayed input binary data signal and to provide its output to a respective data-forwarding stage.

14. A method (600) for operating a true single-phase clock storage unit, the method comprising:
- receiving (602) a clock signal;
- receiving (604) an input binary data signal;
- generating and providing (606), in dependence on an occurrence of a clock-based forwarding trigger event in the received clock signal, a first comparison binary value that is correlated to the value of the input binary data signal;
- receiving (608) the first comparison binary value from the data-forwarding unit and an external second comparison binary value for comparing to the first comparison binary value; and
- providing (610), when the first and the second comparison binary values have the same binary value, and in dependence on an occurrence of a clock-based comparison trigger event immediately consecutive to the forwarding trigger event, an output binary value that is correlated to the first comparison binary value.
